# EUROPEAN PATENT APPLICATION

(11) **EP 2 154 466 A1**
(43) Date of publication of application: **17.02.2010**
(21) Application number: 08275044.9
(22) Date of filing: 13.08.2008
(51) Int. Cl.: F28F 13/00, F28D 20/02, F28F 3/12

(54) **Equipment cooling**

(71) Applicant: BAE Systems PLC, 6 Carlton Gardens London SW1Y 5AD (GB)
(72) Inventor: The designation of the inventor has not yet been filed
(74) Representative: BAE SYSTEMS plc Group IP Department

(57) **Abstract**

Convection cooling channels are provided by means of an at least partially enclosed open cell metal foam structure for removing heat from equipment. In particular, an electronic equipment box is provided having walls comprising sections of open cell aluminium foam, clad with aluminium, through which air or other types of coolant may pass to remove heat from heat-generating components mounted thereon. Other types of equipment, such as electric motors, may be surrounded by customised sections of open cell metal foam, appropriately clad, through which a coolant may be channelled. The foam cell size may be adjusted according to desired coolant flow rate and weight considerations.

Convection cooling structures may be combined with latent heat storage bodies comprising similar open cell metal foam structures containing wax, operating in tandem with the present convection cooling structures in a heat management solution.

## Description

This invention relates to cooling for equipment, in particular but not exclusively to the use of an open cell foam-filled ducting for convection cooling of electronic and other heat-generating equipment.

From a first aspect the present invention resides in an equipment cooling apparatus, comprising a structure formed at least in part by an open cell foam of a thermally conducting material, wherein the structure is arranged to enable a coolant to pass through the foam for removing heat conducted into the foam from equipment to be cooled.

The use of an open cell foam in such a cooled structure has been found to be particularly advantageous in that it provides a large surface area in contact with the coolant and the open cell nature of the material enables coolant to flow relatively easily through the structure.

An open cell foam structure may be formed or cut to any desired shape due to the structurally homogeneous nature of the open cell foam. For example the structure may be shaped to at least partially enclose or to fit closely to the surface of a piece of equipment to be cooled.

In one convenient implementation, the structure comprises a panel of the open cell foam arranged to provide a duct for the passage of the coolant. In a preferred embodiment, one or more such panels may be used to form walls or parts of a wall of a cooled equipment box, or they may be detached from the walls of the box to provide supplemental equipment cooling within the box. Alternatively, or in addition, the equipment box may further comprise a chimney, detached from the walls of the box, formed using the open cell foam to provide a supplementary passage for the coolant and for removing heat from equipment thermally linked to it.

In a further preferred embodiment, a panel of the open cell foam may be provided with one or more fans for propelling air through the panel, so forming a self-contained cooled panel for equipment thermally linked to it.

In designing a heat management solution, there are situations where cooling provided by structures according to this first aspect of the present invention may be insufficient, at least for short periods of time. Preferably, therefore, in the cooling apparatus according to this first aspect of the present invention, the structure further comprises an enclosed section formed using the open cell foam and containing a latent heat thermal storage material to provide a heat storage body, thermally linked to that portion of the structure arranged to pass the coolant. In this way, short term demands for higher levels of heat removal may be accommodated with help from the heat storage body while, during times of cooler operation, the cooled portion of the structure may be used to remove heat from the heat storage body. The heat storage body may contain a phase change material such as wax in which the wax would be allowed to set during a cooling phase. However, other types of latent heat thermal storage material may be used in the heat storage body, including solids such as metal hydrides, for example.

The open cell foam may be made using metals, such as aluminium or copper, or other materials with good thermal conductivity. The choice of material may depend upon weight considerations, required levels of thermal conductivity, expansion properties and mechanical robustness, to name but a few considerations. Furthermore, the size of the cells in the foam may be adjusted on the same or similar bases, taking account also of the nature of the coolant and the required rate of flow of the coolant through the open cell foam.

The coolant itself may take a number of different forms. Typically, air may be pumped or allowed to flow freely through the structure. However, other types of gas and various types of liquid may be used as coolants according to the particular cooling application.

Preferred embodiments of the present invention will now be described in more detail and with reference to the accompanying drawings, of which:
Figure 1 is a perspective view of a portion of a cooled electronics equipment box according to a first preferred embodiment of the present invention;
Figure 2 provides two sectional views through a cooled electronics equipment box according to a second preferred embodiment of the present invention;
Figure 3 provides a perspective view of a self-contained cooling panel according to a third preferred embodiment of the present invention;
Figure 4 provides a perspective view and a cross-sectional view of a cooling structure for at least partially enclosing a heat source such as an electric motor, according to a fourth preferred embodiment of the present invention; and
Figure 5 provides a plan view of an equipment box combining cooled panels with heat storage panels according to a fifth preferred embodiment of the present invention.

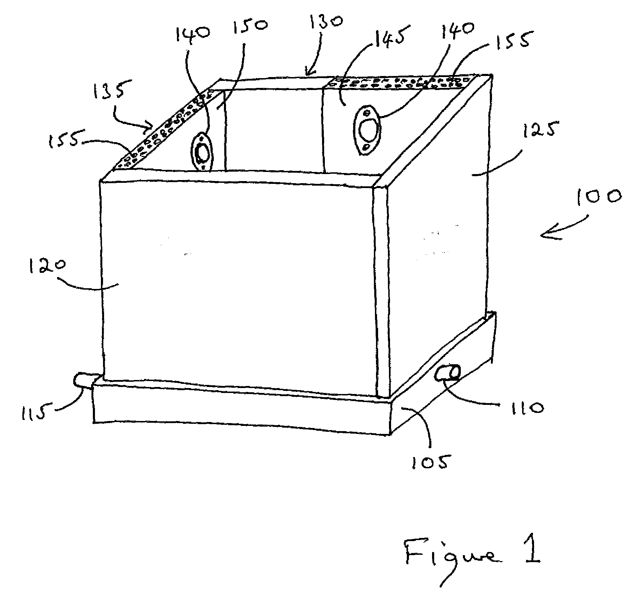

Preferred features according to a first embodiment of the present invention will now be described, with reference to Figure 1, in the context of a cooled electronic equipment box.

Referring to Figure 1, a perspective view is provided of a portion of a cooled electronics equipment box 100 comprising a hollow base plenum chamber 105 having a coolant inlet 110 and a coolant outlet 115, and four walls 120, 125, 130 and 135 fixed to a mounting surface of the plenum chamber 105. Each of the walls 120-135 comprises one or more panels of an open cell aluminium foam, clad in aluminium on those faces forming the inner and outer faces of the box 100. The open-cell nature of the aluminium foam panels allows for the flow of air, or other types of coolant such as water, through selected sections of the walls 120-135. Coolant is able to flow from the plenum chamber 105 into selected panels through holes or slots (not shown in Figure 1) formed in the mounting surface of the plenum chamber 105 and, after flowing through the selected panels, may emerge into a lid (not shown in Figure 1) comprising a similar plenum chamber into which the coolant may flow through corresponding holes or slots. The cladding on the faces of each panel ensures that the panels act as foam-filled ducts through which the coolant may flow without entering the box 100 itself.

Cladding or other types of divider may be provided between panels within or between walls 120-135 of the box 100 to direct or to increase the flow rate of coolant to selected panels, in particular to those having heat-producing components mounted thereon or otherwise thermally linked thereto. The relative positioning of holes or slots in the mounting surface of the base 105 and of dividers between panels may be arranged to provide for any desired route through the panels for coolant to flow. Coolant may for example enter one panel from the plenum chamber 105 and flow through that and an adjacent panel before emerging from the adjacent panel into a lid.

Sources of heat in an electronic circuit, e.g. power transistors 140, are shown in Figure 1 fixed directly to the inner walls of panels 145 and 150 of the box 100. Those panels 145, 150 in particular have been arranged to receive a flow of coolant from the plenum chamber 105. In an alternative arrangement, a heat source may be attached to a heat path of high thermal conductivity, made using metal encapsulated anisotropic graphite or another high-conductivity material, arranged to conduct heat to the inner wall of such a panel 145, 150 for removal.

Omitted from the view provided in Figure 1 is a plenum chamber lid arranged to receive and remove coolant emerging from selected ones of the wall panels 120-135. In the box 100 shown in Figure 1, the open cell structure of one panel in each of the walls 130 and 135 has been exposed (155) to allow coolant to emerge from those panels and to flow into the plenum chamber lid when mounted on the box 100.

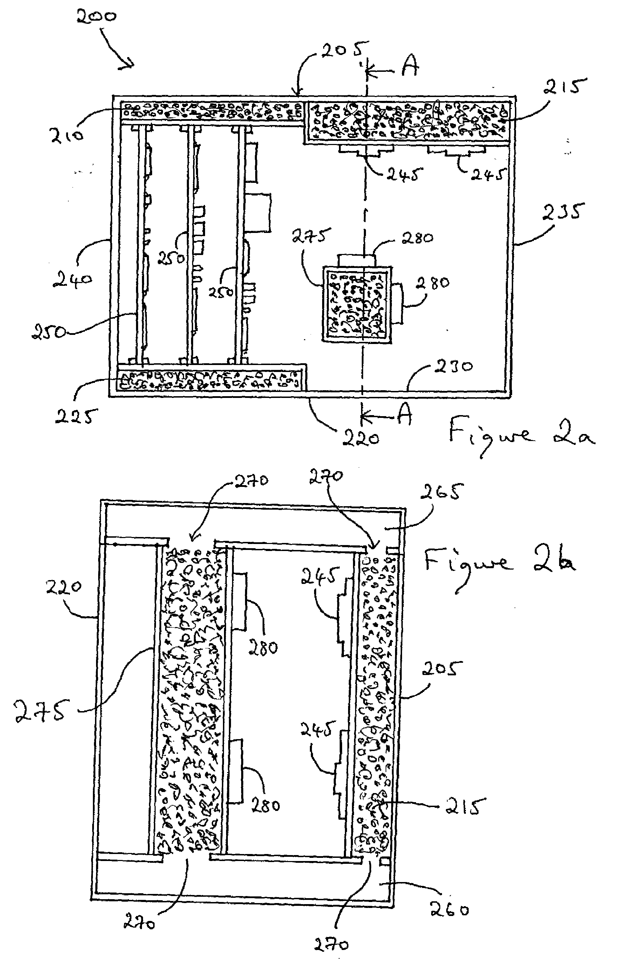

In the particular example of a box 100 in Figure 1, each of the walls 120-135 is constructed from aluminium foam panels of substantially the same thickness and hence of volume. However, according to the heat management requirements for the electronics intended for mounting in the box 100, one or more of the panels may be of greater thickness than the others, or some of the panels may comprise only aluminium sheeting of appropriate thickness with no convection cooling duct provided. An example of this is shown in sectional views through an alternative electronic equipment box in Figure 2 according to a second preferred embodiment of the present invention.

Referring to Figure 2a and to Figure 2b, a plan view and a cross-sectional view, respectively, are provided through an electronic equipment box 200. Figure 2a shows the box 200 in section through a plane parallel to a plenum chamber base 260 of the box 200. Figure 2b provides a cross-sectional view through the same box in a plane indicated by A-A in Figure 2a, perpendicular to the plenum chamber base 260 of the box 200.

The box 200 is provided with one wall 205 comprising two open cell aluminium foam panels 210, 215 of differing thicknesses; the panel 215 having a greater thickness and hence of volume of open cell aluminium foam than the panel 210. A wall 220 of the box 200 is also provided with an open cell aluminium foam panel 225 similar in thickness to the panel 210, but the remainder of the wall 220 comprises a section 230 of aluminium sheeting, as do the other two walls 235 and 240 of the box 200. Four power transistors 245 are shown mounted on the inner wall of the panel 215 and three circuit boards 250 are shown in position within the box 200 with their mounting edges in thermal contact with the panels 210 and 225.

Whereas open cell aluminium foam panels have been shown to provide both walls and coolant channels in an electronic equipment box 200, further cooling may be provided by inserting an appropriately clad, open cell aluminium foam chimney 275 through the equipment box 200, as shown in section in Figure 2a and 2b. As with the panels 210, 215, 225, coolant may flow through the open cell foam of the chimney 275. The profile of the chimney 275 may be tapered, as in a conventional chimney, to improve the ducting of coolant through the chimney. Heat sources 280 may be mounted or otherwise thermally linked to the chimney 275 in the same way as for a wall panel 210, 215, 225.

Referring in particular to Figure 2b, the sectional view A-A though the box 200 shows the plenum chamber base 260 and lid 265 in place on the box 200 with the panel 215 and the aluminium wall section 230 shown in position mounted between them. Holes or slots 270 are provided in the mounting surfaces of the base 260 and the lid 265 to enable coolant to flow between the base 260 and the lid 265 through the open cell aluminium foam of the panel 215 and the chimney 275, in either direction, to remove heat from the power transistors 245 and heat sources 280 respectively.

The increased surface area of open cell thermally conducting foams in comparison with alternative heat transfer features such as fins or pins placed in the path of a flowing coolant, makes for a more effective heat transfer device while providing high structural rigidity in a lightweight electronics equipment box. The open cell foam is suitable for use with air coolants or with liquid coolants such as water, although increased attention to the effective sealing of joints is required if liquid coolants are to be used, as would be apparent to a person of ordinary skill in the relevant art.

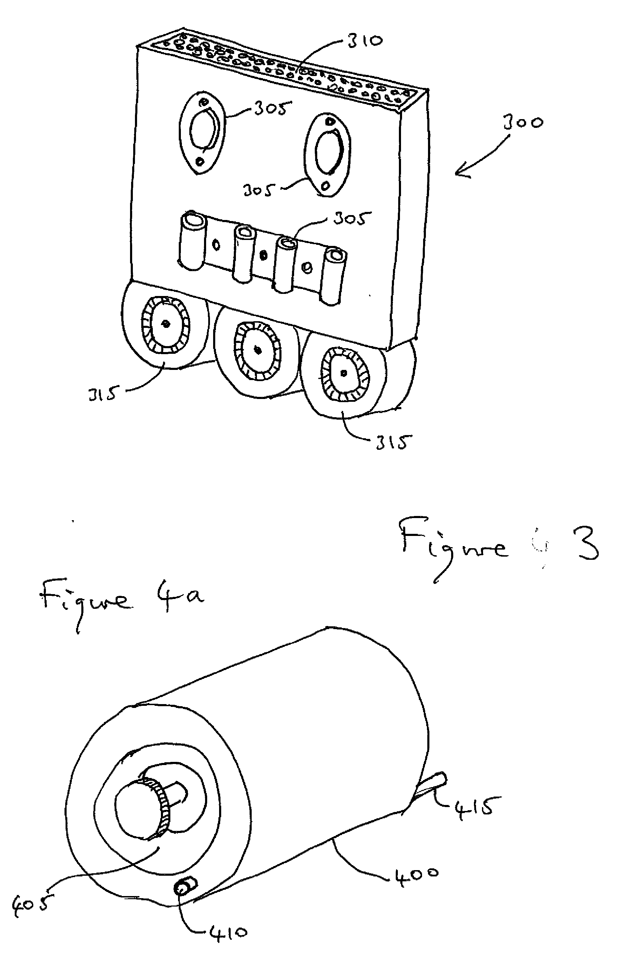

In situations where an equipment box is not required, but a more self-contained cooling arrangement is required, for example in the form of panel, a arrangement according to a third embodiment of the present invention may be used. This arrangement will now be described with reference to Figure 3.

Referring to Figure 3, a perspective view is provided of a self-contained cooled panel 300 having heat-producing components 305 mounted thereon. The panel 300 comprises an open cell aluminium foam panel clad on both main faces and on two of the four edges, leaving one edge 310 open to the atmosphere and the opposite edge open for the mounting of three low voltage motorised fans 315 to blow air through the panel and out of the exposed edge 310, so carrying heat away from the mounted components 305. The panel 300 may be changed in size and shape, in all three dimensions, and the number and type of fans may be changed to suit different applications as required, without departing from the scope of the present invention as regards this third preferred embodiment. Furthermore, if a liquid coolant is used, the fans are replaced by one or more pumps.

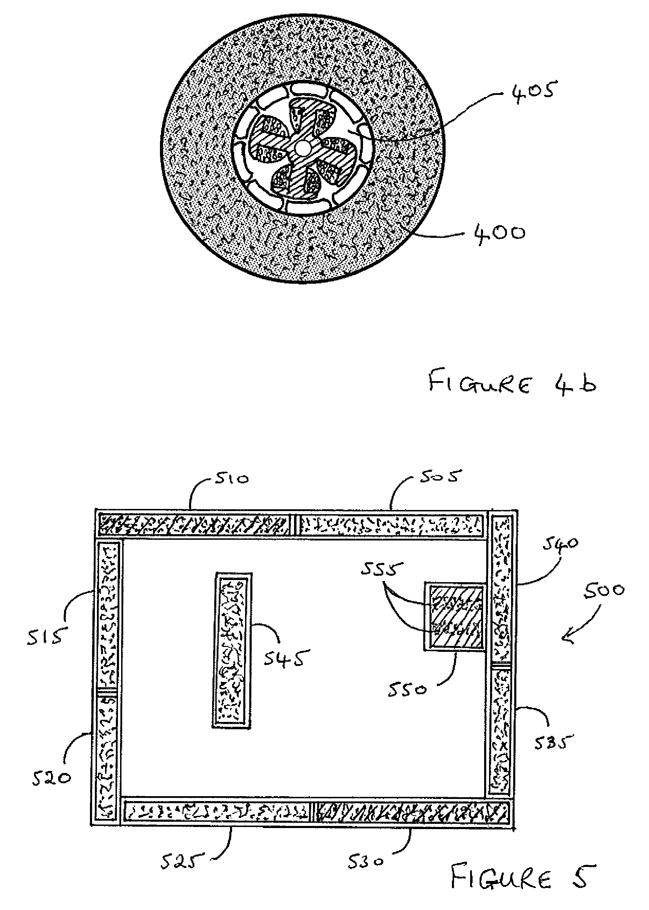

A further application of open cell thermally conducting foam to the removal of heat from equipment will now be described with reference to Figure 4 according to a fourth preferred embodiment of the present invention.

Referring to Figure 4a and to Figure 4b, a perspective and a cross-sectional view are provided, respectively, of an enclosing structure comprising a body 400 of open cell aluminium foam through which a hole has been formed to accommodate an electric motor 405. The foam has been clad in aluminium on all the exposed surfaces. A coolant inlet 410 and a coolant outlet 415 are provided such that coolant may flow through the enclosing open cell foam structure to remove heat from the electric motor 405. The volume of the enclosing structure may be adjusted, for example according to the amount of heat likely to be generated by the electric motor, the flow rate of the coolant through the structure and the available space. The external shape of the enclosing foam structure 400 does not need to correspond to that of the equipment being enclosed and cooled.

Of course, any shape of enclosure may be provided to completely or partially surround a source of heat with a structure functionally equivalent to that shown in Figure 4, clad as required to contain the coolant as it flows through the open cell foam enclosure from one or more inlets to one or more outlets. The body 400 may be changed in size and shape, to suit the object to be cooled. In the case of the coolant being air, the foam may be unclad in suitable locations, so that the air can enter and exit the foam without needing to fabricate the inlet 410 and outlet 415 as physical entities.

Whereas preferred embodiments of the present invention have been described as using open cell aluminium foam in particular, other metals and other materials, having good thermal conductivity, may be used for the foam and the cladding. For all embodiments, the choice of material (foam or cladding) may be varied to achieve different mechanical or thermo-mechanical properties such as strength, stiffness, coefficient of thermal expansion, etc. according to particular requirements of the application. For example, copper may be used where weight is not as critical. Furthermore, the cell structure may be altered to provide larger or smaller cell sizes according to the available surface area required for the transfer of heat to the coolant, the type and the required flow rate of coolant through the open cell structure and the resultant weight of the structure.

In providing a heat management solution, besides providing enhanced convention cooling by the techniques described above, it may be advantageous to incorporate one or more heat storage bodies into a cooling arrangement. A heat storage body, based for example upon a phase change material such as wax, may be used to accommodate short term higher levels of heat which may be beyond the capability of the convection cooling structure to handle without an undesirable increase in temperature of the cooled equipment.

Improved heat storage bodies have been developed by the present Applicant, making use of an open cell foam structure similar to that used in preferred embodiments of the present invention to spread heat more effectively through the phase change material. Such improved heat storage bodies are described in a co-pending patent application by the present Applicant.

Conveniently, a structure comprising thermally linked sections of open cell foam may be made initially without needing to decide which portions will carry a coolant for convection cooling and which portions will be filled with wax for heat storage. Having established the position of heat sources to be cooled, a corresponding arrangement of convection cooling and heat storage portions of the cooling structure may be designed and easily implemented. For example, an equipment box with walls made from isolated panels of open cell aluminium foam may be easily adapted to a particular application by using one or more panels as heat storage bodies and others as convection cooling ducts. One particular example of such an equipment box will now be described with reference to Figure 5, according to a fifth preferred embodiment of the present invention.

Referring to Figure 5, a plan view is provided showing a cross-section through an equipment box 500 similar in configuration to that shown in Figure 1 in that the walls of the box 500 comprise eight discrete panels 505-540, each formed using an open cell aluminium foam clad in aluminium on its largest faces and on the upstanding internal and external edges. Any of the panels 505-540 may be linked to a plenum chamber in a base and a lid or the box 500 (not shown in Figure 5) for the passage of a coolant by means of holes of slots as required. Similarly, any of the panels may contain a phase change material such as wax and be used as a heat storage body. In the particular example shown in Figure 5, two of the panels 510 and 530 contain wax and the remaining panels 505, 515, 520, 525, 535 and 540 remain open and available for the passage of a coolant.

In addition to the walls of the box 500, further structures are provided within the box 500 to supplement the cooling provided by the walls 505-540. In particular, an additional panel 545 has been provided for the passage of coolant and a square-sectioned heat storage body 550 has been provided comprising an enclosure containing two portions 555 of open cell aluminium foam containing wax. The heat storage body 555 has been thermally bonded to the internal face of the panel 540 so that during a cooling phase of the heat storage body 555, heat may be conducted away by the cooled panel 540.

In principle, and as would be apparent to a person of ordinary skill in the relevant art, a cooled equipment box may comprise any desired combination of heat storage panels and coolant panels, with different panels having different sizes if required. Any combination of additional coolant carrying structures and heat storage bodies may be provided within the box, such as those (545, 550) shown in Figure 5. Such structures are not limited to panel-like structures and may be shaped according to available space or to the shape of the equipment to be cooled.

While the use of cooled structures in combination with heat storage bodies, both formed using open cell foams of thermally conducting material, has been described in the context of an equipment box in this preferred embodiment of the present invention, any other type or shape of structure may be formed using such foam materials, appropriately enclosed, according to the physical requirements of the equipment to be cooled and overall heat management requirements. Structures such as that described above with reference to Figure 4 may comprise one or more partitioned sections to be made into heat storage portions, containing a suitable latent heat thermal storage material. Conveniently, the heat storage portions of such a structure may closely resemble the coolant conducting portions as regards their physical structure, so simplifying the manufacture of such structures.

## Claims

1. An equipment cooling apparatus, comprising a structure formed at least in part by an open cell foam made using a thermally conducting material, wherein said structure is arranged to enable a coolant to pass through the foam for removing heat conducted into the foam from equipment to be cooled.

2. The equipment cooling apparatus according to claim 1, wherein said structure comprises a panel of said open cell foam arranged to provide a duct for the passage of said coolant.

3. The equipment cooling apparatus according to claim 2, wherein said apparatus is a cooled equipment box and said panel is a structural component of the box.

4. The equipment cooling apparatus according to claim 3, wherein said panel forms at least a part of a wall of the box.

5. The equipment cooling apparatus according to claim 3, wherein said box further comprises a panel of said open cell foam that is detached from the walls of the box and provides equipment cooling within the box.

6. The equipment cooling apparatus according to any one of claims 3 to 5, wherein the equipment box further comprises a chimney, detached from the walls of the box, formed using said open cell foam to provide a supplementary passage for said coolant and for removing heat from equipment thermally linked thereto.

7. The equipment cooling apparatus according to claim 2, wherein said panel is provided with propelling means for propelling said coolant through the panel.

8. The cooling apparatus according to claim 1, wherein said structure is shaped to correspond with the shape of a piece of equipment to be cooled.

9. The cooling apparatus according to claim 8, wherein said structure is shaped to at least partially enclose the piece of equipment to be cooled.

10. The cooling apparatus according to any one of the preceding claims, wherein said structure further comprises an enclosed section formed using said open cell foam and containing a latent heat thermal storage material to provide a heat storage body, thermally linked to that portion of the structure arranged to pass said coolant.

11. The equipment cooling apparatus according to any one of the preceding claims, wherein said coolant comprises a gas or a mixture of gases.

12. The equipment cooling apparatus according to any one of claims 1 to 10, wherein said coolant comprises a liquid.
